# EUROPÄISCHE PATENTSCHRIFT

(11) **EP 0 293 398 B1**
(45) Veröffentlichungstag und Bekanntmachung des Hinweises auf die Patenterteilung: **28.07.1993**
(21) Anmeldenummer: 87906294.1
(22) Anmeldetag: 01.10.1987
(51) Int. Cl.: G05D 16/20

(54) **VERFAHREN UND EINRICHTUNG ZUM STEUERN VON SICHERHEITSVENTILEN**
PROCESS AND DEVICE FOR THE CONTROL OF SAFETY VALVES
PROCEDE ET DISPOSITIF DE COMMANDE DE SOUPAPES DE SECURITE

(30) Priorität: 04.10.1986 DE 3633851
(43) Veröffentlichungstag der Anmeldung: 07.12.1988
(73) Patentinhaber: Bopp & Reuther Aktiengesellschaft, D-68305 Mannheim (DE)
(72) Erfinder: HARTFIEL, Johannes, D-6800 Mannheim 31 (DE); SCHMITT, Manfred, D-6701 Friedelsheim (DE)
(74) Vertreter: Fritsch, Klaus, Dipl.-Ing.
(86) Internationale Anmeldenummer: DE8700446
(87) Internationale Veröffentlichungsnummer: WO8802510

(56) Entgegenhaltungen:
- EP-A- 0 149 010
- DE-A- 3 124 904
- US-A- 3 665 945

## Beschreibung

Die Erfindung bezieht sich auf ein Verfahren und eine Einrichtung zum Steuern von Sicherheitsventilen, bei dem bzw. bei der der Verschlußkörper von einem an einen Hydrauliksteuerkreis angeschlossenen Stellzylinder gegen den Druck des abzusichernden Mediums auf den Ventilsitz gedrückt wird, wobei bei Erreichen des Ansprechdruckes zur Erzielung des Ventilöffnungshubes ein oder mehrere von Druckaufnehmern gesteuerte Abflußmagnetventile öffnen und die Hydraulikflüssigkeit aus dem Stellzylinder abführen, die bei Unterschreiten des Ansprechdruckes wieder schließen, wobei dem Stellzylinder für den Ventilschließvorgang Hydraulikflüssigkeit zugeführt wird.

Bei einem derartigen bekannten Steuerverfahren für Sicherheitsventile steht der Stellzylinder über eine Drossel ständig mit der Druckleitung des Hydrauliksteuerkreises in offener Verbindung, und bei Erreichen des Ansprechdruckes sprechen Druckschalter an, die die Abflußmagnetventile öffnen und so lange offen halten, bis der Mediumdruck die Schaltschwelle der Druckschalter unterschritten hat. Durch den ständig anstehenden Belastungsdruck fließt nach Schließen der Magnetventile Hydraulikflüssigkeit in den Stellzylinder und schließt das Sicherheitsventil wieder.

Nachteilig bei dieser bekannten Steuereinrichtung ist es, daß redundant angeordnete Magnetventile einen der höchsten Druckanstiegsgeschwindigkeit im Medium angepaßten Durchströmquerschnitt haben müssen, so daß bei einem sehr langsamen Druckanstieg eine zu große Menge des abzusichernden Mediums abgeführt wird und dadurch unerwünscht starke Druckabfälle im Medium und hohe Mediumverluste auftreten können. Diese Druckeinbrüche laufen als Druckwelle durch die Rohrleitung und führen zu Erschütterungen des Sicherheitsventils und der Rohrleitung. Die Druckwellen können auch die Druckschalter erreichen, so daß das Sicherheitsventil dann ständig ungewollt öffnet und schließt. Bei dieser bekannten Steuereinrichtung erfolgt das Öffnen und Schließen des Sicherheitsventils nach einer durch die Hydraulik festgelegten Öffnungsgeschwindigkeit, und eine Anpassung an eine andere Öffnungs- und Schließcharakteristik ist hier nicht möglich. Da der Hydraulikdruck über die Drossel ständig am Stellzylinder ansteht, wird das Sicherheitsventil nach jedem Schließen der Abflußmagnetventile wieder geschlossen, so daß bleibende Zwischenstellungen des Ventilverschlußkörpers nicht möglich sind. Beim Abführen von Teilmengen muß dieses Sicherheitsventil daher ständig öffnen und schließen.

Aufgabe der Erfindung ist es, ein Verfahren und eine Einrichtung zum Steuern von Sicherheitsventilen zu finden, bei dem bzw. bei der das Sicherheitsventil bei hoher Druckanstiegsgeschwindigkeit im Gefahrensfalle schnell große Mediummengen abführt, jedoch bei einem langsamen Druckanstieg nur so weit und so lange öffnet, wie die kleine zum Ausgleich des geringen Druckanstieges notwendige Mediummenge zum Abführen benötigt, und außerdem das Öffnungs- und Schließverhalten des Sicherheitsventils jederzeit an die jeweiligen Anlagebedingungen anpaßbar ist.

Die Lösung dieser Aufgabe wird in den Verfahrensmerkmalen des Anspruchs 1 gesehen.

Dadurch, daß für die verschiedensten Anlagebedingungen jeweils angepaßte Kennlinien für den Hub des Ventilverschlußkörpers erstellt, elektronisch gespeichert und über einen Rechner in Hubschritte umgesetzt werden, läßt sich ein und dasselbe Sicherheitsventil allein durch Eingabe anderer Hubkennlinien für die verschiedensten Anlagen verwenden. Da der Mediumdruck in kurzer Taktzeit gemessen wird, kann im Rechner bereits die geringste Druckänderung erkannt und diese Druckänderung zur Abführung kleinster Mengen an Hydraulikflüssigkeit benutzt werden, so daß der Ventilöffnungsvorgang in vielen kleinen Öffnungsteilschritten erfolgen kann. Nähert sich hierbei die Druckänderungsgeschwindigkeit dem Wert Null, so bleibt das Sicherheitsventil in der erreichten Hubstellung stehen und führt die Überschußmenge ständig ab. Durch diese durch das schrittweise Öffnen oder Schließen des Sicherheitsventils erzielte Feinanpassung werden Druckeinbrüche, wie sie bei bekannten Ventilen durch einen zu großen Öffnungshub auftreten, mit Sicherheit vermieden.

Da der Rechner aus dem Systemdruck und der Druckänderungsgeschwindigkeit für jeden Takt die dazugehörigen Hubschritte des Ventilverschlußkörpers entsprechend den gespeicherten Kennlinien errechnet, läßt sich das Ventilverhalten in einfacher Weise auf die Anlagebedingungen einstellen und kann jederzeit durch Änderung der Kennlinien ohne Außerbetriebnahme der Ventileinrichtung den veränderten Anlagebedingungen angepaßt werden.

Im Rechner wird außerdem für jeden Takt die aus dem Stellzylinder abzuführende oder die dem Stellzylinder zuzuführende Menge der Hydraulikflüssigkeit berechnet und hieraus werden die elektrischen Öffnungspulse der Magnetventile für jeden Takt festgelegt, wobei zur Abführung oder Zuführung kleinster Hydraulikflüssigkeitsmengen und damit zur Durchführung selbst kleinster Hubschritte des Ventilverschlußkörpers schnellansprechende Abflußmagnetventile und Zuflußmagnetventile Verwendung finden, deren kürzesten Ansprechzeiten beispielsweise bei 2 ms liegen. Die Abfrage- und Rechnertaktzeit läßt sich bei diesen kurzen Ansprechzeiten der verwendeten Magnetventile ebenfalls sehr kurz wählen, so daß jederzeit eine Feinanpassung an die sich ändernden Druckverhältnisse das abzusichernden Systems erfolgen kann. Die für jeden Takt festgelegten Öffnungspulse werden über einen Verstärker an die Abfluß- oder Zuflußmagnetventile abgegeben, die dann für die Dauer der errechneten Öffnungszeit offen bleiben und dadurch den Öffnungs- oder Schließvorgang des Sicherheitsventils in Übereinstimmung mit den eingegebenen Kennlinien bei niedrigen Druckänderungsgeschwindigkeiten in kleinen Hubschritten und bei hohen Druckänderungsgeschwindigkeiten in großen Hubschritten steuern. Bei sehr hohen Druckänderungsgeschwindigkeiten dagegen erfolgt der Öffnungs- oder Schließvorgang in einem einzigen Hubschritt bis zur Hubendstellung.

Dieses Steuerverfahren läßt sich gemäß Anspruch 2 auch auf Sicherheitsabsperrventile anwenden, bei denen der Ventilverschlußkörper sich bei einem Druck unterhalb des Ansprechdruckes in Offenstellung befindet und bei Überschreiten des Ansprechdruckes durch schrittweises Abführen der Hydraulikflüssigkeit aus dem Stellzylinder in die Schließstellung gefahren wird.

Zweckmäßigerweise liegen entsprechend den Merkmalen des Anspruchs 3 die eingegebene Kennlinie oder die Kennlinien in einem zwischen einem unteren Ansprechdruck Pu und einem oberen Ansprechdruck P₀ vorgesehenen Druckbereich, und der Rechner führt nur in diesem Druckbereich im Takt die Berechnung der Öffnungspulse für die schnellansprechenden Magnetventile durch. Da das Sicherheitsventil durch die vorgeschlagene Steuerung auf kleinste Druckänderungen reagiert und der Ventilverschlußkörper auch in jeder Zwischenstellung stehen bleiben kann, wenn die abgeführte Mediummenge des abzusichernden Drucksystems groß genug ist, um den Druck konstant zu halten, kann der Druckbereich zwischen P₀ und Pu klein gehalten werden. Erfahrungsgemäß kann bei höheren Ansprechdrücken der Druckunterschied zwischen P₀ und Pu etwa 5 % des oberen Ansprechdruckes P₀ betragen. Liegen die Mediumdrücke oberhalb des oberen Ansprechdruckes P₀ oder unterhalb des unteren Ansprechdruckes Pu, kann die Schrittsteuerung außer Betrieb bleiben. Bei Überschreiten des oberen Ansprechdruckes P₀ gibt nämlich der Rechner anstelle der Öffnungspulse ein Daueröffnungssignal an den auf die Abflußmagnetventile einwirkenden Verstärker, und bei Unterschreiten des unteren Ansprechdruckes Pu wird ein Dauerschließsignal an die Abflußmagnetventile abgegeben.

Die in Abhängigkeit der Druckänderungsgeschwindigkeit erfolgende schrittweise Hubverstellung des Ventilverschlußkörpers ist dann nicht mehr sinnvoll, wenn der Systemdruck extrem schnell ansteigt oder fällt. In diesem Fall wird entsprechend den Merkmalen des Anspruchs 4 vorgeschlagen, daß im Rechner nur die Berechnung der Öffnungspulse für die Magnetventile bis zum Erreichen hoher Grenzwerte der Druckänderungsgeschwindigkeit einerseits für den Öffnungsvorgang und andererseits für den Schließvorgang des Sicherheitsventils durchgeführt wird. Bei Überschreiten dieser Grenzwerte wird deshalb vom Rechner bei steigendem Druck ein Daueröffnungssignal für die Abflußmagnetventile und bei fallendem Druck ein Daueröffnungssignal für die Zuflußmagnetventile an den steuernden Verstärker abgegeben. Dadurch wird bei extrem schnellem Druckanstieg, d. h. im Gefahrensfalle erreicht, daß das Sicherheitsventil mit seiner höchstmöglichen Geschwindigkeit öffnet. Andererseits wird bei extrem hohem Druckabfall vermieden, daß eine zu große Mediummenge verloren geht.

Ein feineres Ansprechen der Steuerung bei niedrigen Druckanstiegsgeschwindigkeiten und ein schnelleres Ansprechen bei höheren Druckanstiegsgeschwindigkeiten wird gemäß dem Anspruch 5 dadurch erreicht, daß schnellansprechende Magnetventile mit veränderbarem Öffnungsquerschnitt vorgesehen sind. Dadurch läßt sich die abzuführende oder zuzuführende Menge an Hydraulikflüssigkeit nicht nur durch die Öffnungszeit sondern auch durch die unterschiedlichen Öffnungsquerschnitte der Magnetventile bestimmen, wodurch die Spanne zwischen der kleinsten und der größten abzuführenden bzw. zuzuführenden Menge an Hydraulikflüssigkeit wesentlich vergrößert wird. Die möglichen Änderungen der Öffnungsquerschnitte der verwendeten Magnetventile werden elektronisch gespeichert und bei der Berechnung der Öffnungspulse werden die jeweils verwendeten Öffnungsquerschnitte der Magnetventile berücksichtigt.

Werden als schnellansprechende Magnetventile entsprechend dem Merkmal des Anspruchs 6 vorgesteuerte Magnetventile vorgesehen, so wird der jeweils freie Strömungsquerschnitt selbsttätig durch die Dauer der Öffnungspulse gesteuert. Bei kurzen Öffnungspulsen öffnet nur der Vorsteuerkegel mit kleinem Querschnitt, während bei längeren Öffnungspulsen der große Hauptkegelquerschnitt freigegeben wird.

Will man die Stellzeiten für den Hub des Ventilverschlußkörpers noch weiter verkürzen, so empfiehlt sich entsprechend den Merkmalen des Anspruchs 7 die Anordnung mehrerer schnellansprechender Magnetventile mit gleichem oder unterschiedlichem Öffnungsquerschnitt in Parallelschaltung. Bei großen ab- oder zuzuführenden Mengen der Hydraulikflüssigkeit kann dann das parallelgeschaltete Magnetventil zugeschaltet werden, so daß sich der Durchströmquerschnitt verdoppelt oder bei mehreren Magnetventilen sogar vervielfacht.

Damit die Berechnung der Öffnungspulse im Rechner fehlerfrei erfolgen kann, wird entsprechend dem Anspruch 8 weiterhin vorgeschlagen, die Anzugszeit und die Abfallzeit der schnellansprechenden Magnetventile bei der Berechnung der Öffnungspulse als Korrekturgröße zu berücksichtigen. Da Druck- und Temperaturänderungen der Hydraulikflüssigkeit die Anzugs- und Abfallzeit der Magnetventile verändern können, wird entsprechend Anspruch 9 vorgeschlagen, diese durch Druck- und Temperaturänderungen verursachten Änderungen der Anzugs- und Abfallzeit der Magnetventile ebenfalls als Korrekturgröße bei der Berechnung der Öffnungspulse zu berücksichtigen.

Da sich beim Öffnen des oder der Abflußmagnetventile der Druck im Stellzylinder verändert und die pro Zeiteinheit durch die Abflußmagnetventile abströmende Menge der Hydraulikflüssigkeit von diesem Stellzylinderdruck abhängig ist, wird entsprechend dem Anspruch 10 vorgeschlagen, den Belastungsdruck im Stellzylinder im Takt zu messen und bei der Berechnung der Öffnungspulse für die Abflußmagnetventile ebenfalls als Korrekturgröße zu berücksichtigen.

Beim Öffnen der den Schließvorgang des Sicherheitsventils auslösenden Zuflußmagnetventile ändert sich der Belastungsdruck im Stellzylinder und außerdem der Druck im Speicher des Hydrauliksteuerkreises. Die pro Zeiteinheit durch die Zuflußmagnetventile strömende Menge an Hydraulikflüssigkeit hängt außer vom Durchflußquerschnitt auch von der Differenz zwischen Speicherdruck und Belastungsdruck ab. Dementsprechend wird gemäß dem Merkmal des Anspruchs 11 die Druckdifferenz zwischen dem Druck im Speicher des Hydrauliksteuerkreises und dem Belastungsdruck im Stellzylinder im Takt gemessen und bei der Berechnung der Öffnungspulse des oder der Zuflußmagnetventile als Korrekturgröße berücksichtigt.

Da die errechneten Hubschritte des Ventilverschlußkörpers von dem tatsächlichen Hub abweichen können, wird entsprechend den Merkmalen des Anspruchs 12 vorgeschlagen, die jeweilige Hubstellung des Sicherheitsventils als Istwert durch einen Wegaufnehmer im Takt zu messen und diesen Istwert mit den errechneten Hubschritten zu vergleichen. Bei auftretenden Differenzen werden die errechneten Öffnungspulse entsprechend korrigiert, so daß Steuerfehler, die durch nicht exakte Hubschritte ausgelöst werden, mit Sicherheit vermieden werden.

Da die Viskosität der Hydraulikflüssigkeit von der Temperatur abhängig ist und die pro Zeiteinheit durch die Magnetventile hindurchströmende Menge der Hydraulikflüssigkeit sich mit zunehmender Viskosität verringert, wird gemäß Anspruch 13 vorgeschlagen, die bekannte Temperatur/Viskositäts-Kennlinie der Hydraulikflüssigkeit elektronisch zu speichern und die Temperatur der Hydraulikflüssigkeit im Takt zu messen. Dadurch kann die sich mit der Temperatur ändernde Viskosität und damit der sich ändernde Strömungswiderstand der Magnetventile bei der Berechnung der Öffnungspulse berücksichtigt werden.

Die Berücksichtigung der Viskosität der Hydraulikflüssigkeit ist nur in einem gewissen Temperaturbereich sinnvoll, da bei zu niedrigen Temperaturen die Hubverstellung des Sicherheitsventils zu langsam vor sich geht und bei zu hohen Flüssigkeitstemperaturen die mit der Hydraulikflüssigkeit in Wärmeleitverbindung kommenden elektrischen oder elektronischen Bauteile der Steuerung, z. B. die Spulen der Magnetventile, geschädigt werden können. Um einerseits ein zu langsames Ansprechen des Sicherheitsventils und andererseits eine Schädigung elektrischer Bauteile zu vermeiden, wird im Anspruch 14 vorgeschlagen, bei Unterschreiten eines unteren Temperaturgrenzwertes der Hydraulikflüssigkeit eine Heizung zur Erwärmung der Hydraulikflüssigkeit und beim Überschreiten eines oberen Temperaturgrenzwertes eine Kühlung selbsttätig einzuschalten. Die Erwärmung des Hydraulikflüssigkeit kann hierbei in einfacher Weise gemäß dem Merkmal des Anspruchs 15 dadurch erfolgen daß bei Unterschreiten des unteren Temperaturgrenzwertes die Hydraulikpumpe des Hydrauliksteuerkreises so lange eingeschaltet wird bzw. bleibt, bis sich die Hydraulikflüssigkeit durch die in Wärmeenergie umgewandelte Verlustleistung des Hydrauliksystems ausreichend erwärmt hat.

Die für die Steuerung des Sicherheitsventils vorgesehene elektronische Einrichtung ermöglicht es auch, die Funktionssicherheit des Sicherheitsventils durch Überwachung der wichtigsten Bauelemente und rechtzeitige Meldung von Störungen zu erhöhen. Hierfür wird entsprechend Anspruch 16 vorgeschlagen, die Zustandsgrößen mindestens der funktionswichtigsten elektrischen, elektronischen und hydraulischen Bauteile im Zyklus zu messen und mit elektronisch gespeicherten Grenzwerten im Rechner zu vergleichen. Bei Grenzwertüberschreitungen gibt der Rechner entsprechende Störungsignale ab, so daß die Störungsursache rechtzeitig behoben und ein eventueller Schaden vermieden werden kann.

Eine zweckmäßige Einrichtung zur Durchführung der vorgenannten Steuerverfahren wird in den Merkmalen der Ansprüche 17 bzw. 18 gesehen. Durch die Anordnung der Abfluß- und Zuflußmagnetventile direkt am Stellzylinder oder in unmittelbarer Nähe desselben und durch die unmittelbare Hinzuschaltung des Vorratsbehälters und des Speichers des Hydrauliksteuerkreises kann die in den kurzen Leitungen verbleibende geringe Menge an Hydraulikflüssigkeit beim Schalten der schnellansprechenden Magnetventile innerhalb der kurzen Ventilstellzeiten auf die gewünschte Strömungsgeschwindigkeit beschleunigt werden, so daß sich kurze Stellzeiten für die Ventilhübe ergeben. Durch die Zusammenfassung aller elektronischer Baugruppen, wie Rechner, Speicher, Verstärker und dergleichen zu einer Elektronikbaueinheit, die einerseits an die Magnetventile und andererseits an den Druckaufnehmer angeschlossen ist, ergibt sich eine übersichtliche Anordnung der Gesamtanlage.

Durch die Anordnung von drei unabhängig voneinander arbeitenden Druckaufnehmern entsprechend Anspruch 19, die mit redundant angeordneten Magnetventilen zusammenwirken, wird eine sehr hohe Betriebssicherheit der Steuereinrichtung erzielt. Die Steuerung der Hubschritte erfolgt hierbei über das eine Abflußmagnetventil in dem Druckbereich zwischen dem unteren Ansprechdruck Pu und dem oberen Ansprechdruck P₀, während die beiden anderen direkt von den Druckschaltern gesteuerten Abflußmagnetventile entsprechend Anspruch 20 erst bei Überschreiten des oberen Ansprechdruckes P₀ aufgesteuert werden. Dadurch ist auch bei Ausfall der elektronischen Steuerung das sichere Öffnen des Sicherheitsventils gewährleistet.

Zweckmäßigerweise werden alle hydraulischen Bauteile gemäß den Merkmalen des Anspruchs 21 auf engstem Raum in einem topfartigen Gehäuse eingebaut,das gleichzeitig den Vorratsbehälter für die Hydraulikflüssigkeit bildet. Durch diese Anordnung erhält man die kürzesten Leitungsverbindungen zwischen den einzelnen hydraulischen Bauteilen, und die Bauteile sind durch den Topf gegen mechanische äußere Einflüsse geschützt. Eine explosionsgeschützte Ausführung ergibt sich hierbei in einfacher Weise dadurch, daß gemaß Anspruch 22 alle elektrischen Teile des Hydrauliksteuerkreises, die in den Vorratsbehälter eingebaut sind, von einem elektrisch nichtleitenden Hydrauliköl als Vorratsöl umspült sind. Dadurch werden gleichzeitig die im Öl liegenden Teile gegen Überhitzung geschützt.

Der die Hydraulikteile enthaltende Vorratsbehälter läßt sich durch die gedrungene Ausbildung in einfacher Weise gemäß Anspruch 23 auf den Stellzylinder aufsetzen, wodurch die kürzesten Verbindungswege vom Hydrauliksteuerkreis zum Stellzylinder geschaffen werden und die Anlage besonders kompakt wird. Durch die Kühlrippen gemäß Anspruch 24 wird die wärmeabgebende Oberfläche des Hydraulikgehäuses wesentlich vergrößert, so daß eine hohe Verlustleistung schnell an die Umgebung abgegeben werden kann. Werden entsprechend dem Merkmal des Anspruchs 25 im Hydrauliksteuerkreis zwei parallelgeschaltete Speicher vorgesehen, so ist bei Ausfall eines Speichers noch eine einwandfreie Steuerfunktion der Magnetventile gewährleistet, und die beiden Speicher lassen sich auf kleinerem Raum in dem zentralen Gehäuse unterbringen.

Die Erfindung wird in einem Ausführungsbeispiel näher erläutert, wie die Zeichnung erkennen läßt, und zwar zeigt:
- Fig. 1: ein Schaltschema der Steuereinrichtung
- Fig. 2: ein Diagramm, das den schrittweisen Öffnungs- oder Schließvorgang eines Sicherheitsventils erkennen läßt
- Fig. 3: ein Diagramm mit in Abhängigkeit vom Systemdruck erstellten Kennlinien für verschiedene positive und negative Druckänderungsgeschwindigkeiten.

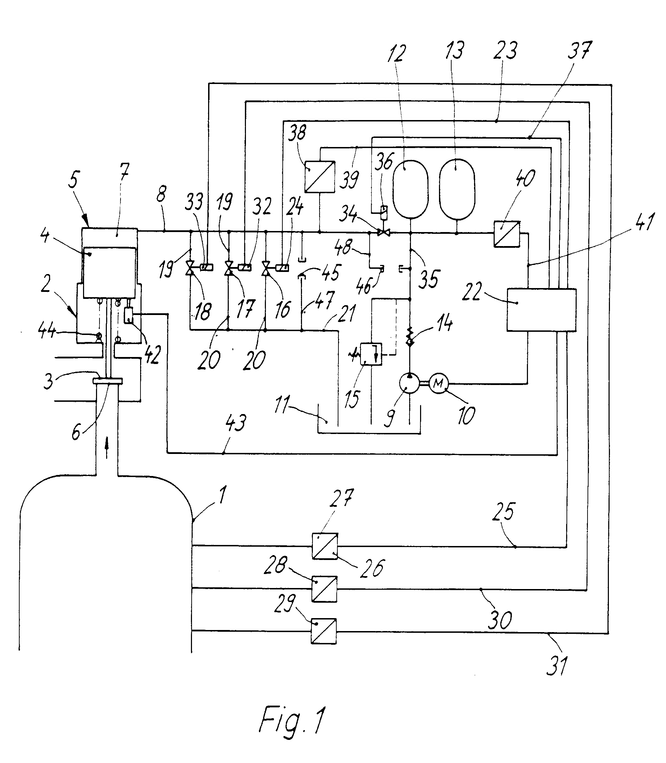

In dem in der Fig. 1 gezeigten Schaltschema ist das abzusichernde System 1 mit einem Sicherheitsventil 2 versehen, dessen Ventilverschlußkörper 3 von dem Kolben 4 eines hydraulischen Stellzylinders 5 auf den Ventilsitz 6 gedrückt wird und dadurch das Sicherheitsventil 2 in Schließstellung hält. Die Belastungskammer 7 des Stellzylinders 5 ist über eine Hydraulikleitung 8 an einen Hydrauliksteuerkreis angeschlossen, der in seinem Grundaufbau aus einer Hydraulikpumpe 9 mit Motor 10, einem Ölvorratsbehälter 11 und zwei parallelgeschalteten Speichern 12 und 13 besteht. Im Hydrauliksteuerkreis sind außerdem noch ein Rückschlagventil 14 und ein Druckbegrenzungsventil 15 vorgesehen.

Die Abführung der Hydraulikflüssigkeit aus der Belastungskammer 7 des Stellzylinders 5 erfolgt über drei parallel zueinander liegenden Abflußmagnetventile 16, 17 und 18, die eingangsseitig über die Zweigleitungen 19 an die Hydraulikleitung 8 und ausgangsseitig über die Zweigleitungen 20 an die zum Ölvorratsbehälter 11 führende Abflußleitung 21 angeschlossen sind. Das Abflußmagnetventil 16 wird von einer Elektronikbaueinheit 22 gesteuert, die über eine Steuerleitung 23 Öffnungspulse auf den elektrischen Schaltteil 24 bzw. die Magnetspule des Abflußmagnetventils 16 überträgt. Die Elektronikbaueinheit 22 steht eingangsseitig über die Meßleitung 25 mit dem elektrischen Signalausgang 26 eines an das abzusichernde System 1 angeschlossenen Druckaufnehmers 27 in Verbindung. Aus Sicherheitsgründen sind zwei weitere Druckaufnehmer 28 und 29 parallel zum Druckaufnehmer 27 an das abzusichernde System 1 angeschlossen, die als Druckschalter ausgebildet sind und über die beiden Steuerleitungen 30 und 31 direkt mit den Magnetspulen 32 und 33 der anderen beiden Abflußmagnetventile 17 und 18 in Verbindung stehen.

Während die drei Abflußmagnetventile 16, 17 und 18 zur Steuerung des Öffnungsvorganges des Sicherheitsventils 2 vorgesehen sind, wird der Schließvorgang des Sicherheitsventils 2 über das Zuflußmagnetventil 34 gesteuert, das eingangsseitig an die Druckleitung 35 des Hydrauliksteuerkreises und ausgangsseitig an die zur Belastungskammer 7 führende Hydraulikleitung 8 angeschlossen ist. Der elektrische Schaltteil 36 bzw. die Magnetspule des Zuflußmagnetventils 34 wird über die Steuerleitung 37 von der Elektronikbaueinheit 22 aus geschaltet.

In der Elektronikbaueinheit 22 sind alle für die Steuerung des Öffnungs- bzw. Schließvorganges des Sicherheitsventils 2 erforderlichen elektronischen Baugruppen wie Rechner, Speicher, Verstärker und die übrigen elektronischen Module zusammengefaßt, wobei im Speicher die vom Mediumdruck und der Druckänderungsgeschwindigkeit bestimmte gewünschte Kennlinie oder die Kennlinien für den Hub des Ventilverschlußkörpers vor Inbetriebnahme der Anlage eingegeben werden. Je nach der Höhe des vom Druckaufnehmer 27 erfaßten Mediumdruckes im abzusichernden System 1 errechnet die Elektronikbaueinheit 22 pro Takt die Druckänderungsgeschwindigkeit und im Vergleich mit der gespeicherten Kennlinie für jeden Takt die Größe des auszuführenden Hubschrittes des Ventilverschlußkörpers. Zur Durchführung dieses Hubschrittes wird in der Elektronikbaueinheit 22 die aus der Belastungskammer 7 abzuführende Ölmenge bestimmt und hieraus der auf das Abflußmagnetventil 16 zu übertragende Öffnungspuls errechnet. Das Sicherheitsventil 2 wird dadurch im Takt schrittweise aufgesteuert. Der Schließvorgang des Sicherheitsventils 2 erfolgt ebenfalls über die Elektronikbaueinheit 22, jedoch jetzt durch schrittweises Steuern des Zuflußmagnetventils 36.

Um den Belastungsdruck im Stellzylinder bei der Berechnung der Öffnungspulse für das Abflußmagnetventil 16 als Korrekturgröße berücksichtigen zu können, ist noch ein Druckaufnehmer 38 an die Hydraulikleitung 8 angeschlossen, dessen elektrischer Ausgang über die Meßleitung 39 mit der Elektronikbaueinheit 22 in Verbindung steht. Ein weiterer Druck- und Temperaturaufnehmer 40 ist an die Druckleitung 35 des Hydrauliksteuerkreises angeschlossen, dessen elektrischer Ausgang über die Meßleitung 41 mit der Elektronikbaueinheit in Verbindung steht. Über diesen Druck- und Temperaturaufnehmer 40 kann der Differenzdruck, der am Zuflußmagnetventil 34 ansteht sowie die Temperatur des Hydrauliköles als Korrekturgröße bei der Berechnung der Öffnungspulse berücksichtigt werden. Um Berechnungsfehler in der Elektronikbaueinheit 22 bei der Festlegung der auszuführenden Hubschritte korrigieren zu können, ist außerdem noch am Kolben 4 des Stellzylinders 5 ein Hubaufnehmer 42 vorgesehen, dessen elektrischer Ausgang über die Meßleitung 43 mit der Elektronikbaueinheit 22 verbunden ist.

Die Ventilöffnungsfeder 44 ist im Sicherheitsventil 2 vorgesehen worden, damit die beweglichen Ventilteile in die Ventiloffenstellung gefahren werden, wenn die abzusichernde Anlage 1 drucklos ist. Die Steuerung des Ventilhubes erfolgt über das Abflußmagnetventil 16 und das Zuflußmagnetventil 34. Erst wenn der Mediumdruck über den oberen Ansprechdruck P₀ ansteigt, öffnen auch die beiden Abflußmagnetventile 17 und 18, die direkt von den Druckschaltern 28 und 29 gesteuert werden. Die Einbauanschlüsse 45 und 46 in den Parallelleitungen 47 und 48 sind vorgesehen worden, damit noch ein zusätzliches Abflußmagnetventil oder ein zusätzliches Zuflußmagnetventil eingebaut werden kann.

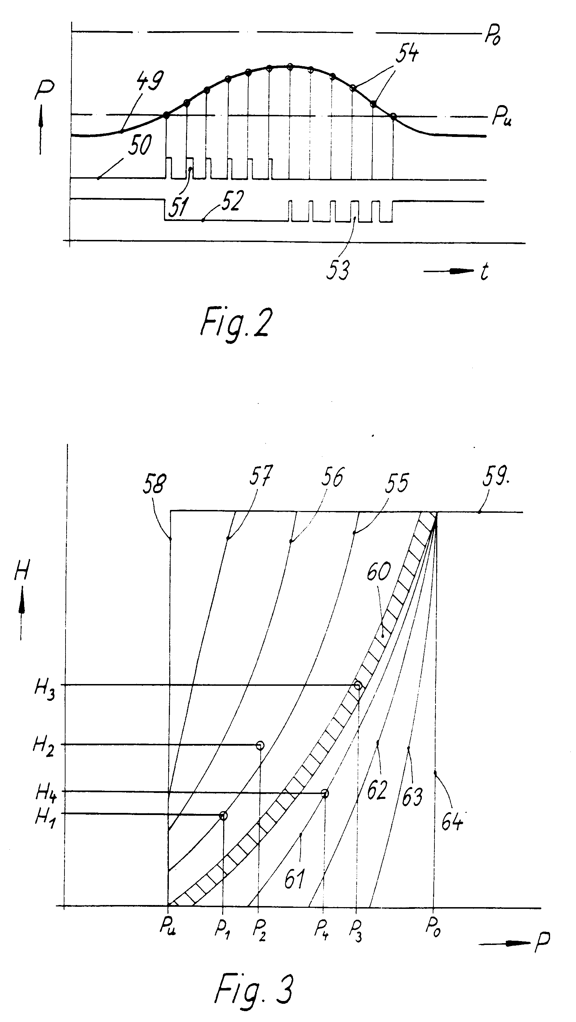

Das in der Fig. 2 dargestellte Diagramm zeigt den Systemdruck P in Abhänigkeit der Zeit t. Die Kurve 49 läßt den Verlauf des Systemdruckes in einem bestimmten Zeitabschnitt erkennen. Die schrittweise Steuerung des Ventilöffnungs- und Ventilschließhubes erfolgt im Druckbereich zwischen dem unteren Ansprechdruck Pu und dem oberen Ansprechdruck P₀, wobei die Kennlinie 50 die Öffnungspulse 51 des Abflußmagnetventils und die Kennlinie 52 die Öffnungspulse 53 des Zuflußmagnetventils zeigt. Die Abstände zwischen den Punkten 54 der Kurve 49 kennzeichnen die einzelnen Takte, in denen die einzelnen Hubschritte erfolgen. Entsprechend der beim Überschreiten des unteren Ansprechdruckes Pu in der linken Hälfte der Fig. 2 ansteigenden Druckkurve 49 wird taktweise der Ventilverschlußkörper 3 in den Schritten 51 angehoben, wodurch in zunehmendem Maße Medium abgeführt wird, so daß die Druckanstiegsgeschwindigkeit im System, die an der Neigung der Kurve 49 erkennbar ist, stetig abnimmt und schließlich in einen waagerechten Verlauf mit der Druckänderungsgeschwindigkeit Null übergeht. Von diesem Augenblick an werden keine Öffnungspulse mehr auf das Abflußmagnetventil übertragen, und der Ventilverschlußkörper 3 verharrt in seiner zuletzt erreichten Hubstellung. Wird die den Druckanstieg im System auslösende Störung aufgehoben, so fällt der Systemdruck, wie die rechte Hälfte der Druckkurve 49 erkennen läßt. Damit das Sicherheitsventil in diesem Druckabfallbereich so langsam schließt, daß keine Druckstöße auftreten, andererseits aber schnell genug schließt, damit keine zu hohen Mediumverluste in Kauf genommen werden müssen, wird der Ventilverschlußkörper durch die auf das Zuflußmagnetventil einwirkenden Öffnungspulse 53 im Takt schrittweise zugefahren, bis der untere Ansprechdruck Pu unterschritten ist. In dieser Ventilschließstellung bleibt das Zuflußmagnetventil 34 in Daueroffenstellung, damit der Hydraulikdruck ständig in der Belastungskammer 7 des Stellzylinders 5 ansteht.

Die Figur 3 zeigt ein Beispiel für die in den elektronischen Speicher einzugebenden Kennlinien für den Hub H in Abhängigkeit vom Systemdruck P und gleichzeitig in Abhängigkeit von der Druckänderungsgeschwindigkeit des Systemdruckes. Der Druckbereich, in dem die Steuerung des Sicherheitsventils schrittweise durchgeführt wird, liegt zwischen dem unteren Ansprechdruck Pu und dem oberen Ansprechdruck P₀. Die Kennlinien 55, 56, 57 und 58 geben die gewünschte Abhängigkeit des Sollhubes von der Druckanstiegsgeschwindigkeit und vom Systemdruck P wieder. Die waagerechte Hubkennlinie 59 kennzeichnet hierbei die Hubendstellung des Sicherheitsventils. Die Kennlinie 55 gilt für eine niedrige Druckanstiegsgeschwindigkeit von z. B. 1 %/s des Ansprechdruckes, während die Kennlinie 58 den oberen Grenzwert der Druckanstiegsgeschwindigkeit von beispielsweise 5 %/s oder mehr des Ansprechdruckes wiedergibt. Die Kennlinien 56 und 57 kennzeichnen ganzzahlige Zwischenwerte in den Druckanstiegsgeschwindigkeiten, wobei die verbleibenden Zwischenräume zwischen diesen Kennlinien durch weitere dazwischenliegende Kennlinien beliebig fein unterteilt werden können. Ist bei Beginn eines beliebigen Taktes beispielsweise der Systemdruck auf den Druck P₁ angestiegen, und beträgt die Druckanstiegsgeschwindigkeit entsprechend der Kennlinie 55 etwa 1 %/ s, so ergibt sich hierfür aus dem Diagramm ein auszuführender Sollhub H₁. Steigt bei dem nächsten Takt der Systemdruck auf den Wert P₂, an und erhöht sich die Druckanstiegsgeschwindigkeit auf einen etwa höheren, zwischen den beiden Kennlinien 55 und 56 liegenden Wert, so ergibt sich ein Sollhub H₂, so daß für diesen Takt der auszuführende Hubschritt aus der Differenz zwischen dem Sollhub H₂ und dem Sollhub H₁ resultiert. Der mittlere schraffierte Bereich 60 gilt für sehr kleine Druckänderungsgeschwindigkeiten, beispielsweise im Bereich von plus/minus 0,1 %/s des Ansprechdruckes. In diesem Bereich wird zur Ermittlung des Sollhubes nur der Systemdruck P herangezogen. Ist der Systemdruck beispielsweise auf einen Wert P₃ angestiegen, und liegt die Druckänderungsgeschwindigkeit im schraffierten Bereich 60, so ergibt sich der Sollhub H₃, so daß ein sich aus der Differenz zwischen H₃ und H₂ ergebender Hubschritt auszuführen ist.

Die andererseits des schraffierten Feldes 60 liegenden Kennlinien 61, 62, 63 und 64 gelten für negative Druckänderungsgeschwindigkeiten, d. h. für fallenden Systemdruck. Die Kennlinie 61 gilt z. B. für eine Druckabfallgeschwindigkeit von 1 %/s des Ansprechdruckes, während die Kennlinien 62 und 63 größere Druckabfallgeschwindigkeiten kennzeichnen. Die Kennlinie 64 gilt für Druckabfallgeschwindigkeiten von beispielsweise 10 %/s oder mehr. Fällt der Systemdruck von P₃ auf P₄ und liegt die Druckabfallgeschwindigkeit auf der Kennlinie 61, so ergibt sich der Sollhub H₄.

Der auszuführende Hubschritt für diesen Takt errechnet sich aus der Differnez H₄ minus H₃. Das Ergebnis ist negativ, woraus erkennbar ist, daß ein Hubschritt in Schließrichtung zu erfolgen hat.

## Patentansprüche

1. Verfahren zum Steuern von einem Sicherheitsventil einer abzusichernden Anlage (2), bei welchem Verfahren der Verschlußkörper (3) des Sicherheitsventils von einem an einen Hydrauliksteuerkreis angeschlossenen Stellzylinder (5) gegen den Druck des Mediums in der abzusichernden Anlage auf den Ventilsitz gedrückt wird, und bei Erreichen des Ansprechdruckes zur Erzielung des Ventilöffnungshubes ein oder mehrere von Druckaufnehmern (27,28,29) gesteuerte Abflußmagnetventile (16,17,18) öffnet und die Hydraulikflüssigkeit aus dem Stellzylinder (5) abführt, die bei Unterschreiten des Ansprechdruckes wieder schließen, wobei dem Stellzylinder (5) für den Ventilschließvorgang Hydraulikflüssigkeit zugeführt wird, **dadurch gekennzeichnet**, daß
a) eine oder mehrere vom Druck und der Druckänderungsgeschwindigkeit dp/dt bestimmte Kennlinien für den Hub des Verschlußkörpers (3) in Anpassung an die abzusichernde Anlage erstellt und in Form von Punkten der Kennlinien oder als Koeffizienten analytischer Funktionen elektronisch gespeichert sind,
b) der Mediumdruck über die Druckaufnehmer (27,28,29) in kurzer Taktzeit gemessen und gespeichert wird,
c) die Druckänderungsgeschwindigkeit in dieser Taktzeit in einem elektronischen Rechner errechnet und entsprechend den gespeicherten Kennlinen für jeden Takt die Größe des dazugehörigen Hubschrittes des Verschlußkörpers (3) für ein schrittweises Öffnen oder Schließen des Sicherheitsventiles (2) festgelegt wird,
d) der elektronische Rechner die pro Takt über ein oder mehrere schnellansprechende Abflußmagnetventile (16,17,18) abzuführende oder die über ein oder mehrere schnellansprechende Zuflußmagnetventile (34) zuzuführende Menge der Hydraulikflüssigkeit berechnet und hieraus die elektrischen Öffnungspulse der Magnetventile (16,17,18;34) für jeden Takt bestimmt und
e) diese Öffnungspulse über Verstärker an die Abfluß- und Zuflußmagnetventile (16,..;34) abgegeben werden, die den Öffnungs- oder Schließvorgang des Sicherheitsventiles (2) in Übereinstimmung mit den eingegebenen Kennlinien bei niedrigen Druckänderungsgeschwindigkeiten in kleinen Hubschritten und bei hohen Druckänderungsgeschwindigkeiten in großen Hubschritten oder in einem einzigen Schritt bis zur Hubendstellung steuern.

2. Verfahren zum Steuern von einem Sicherheitsventil (2) einer abzusichernden Anlage, bei welchem Verfahren der Verschlußkörper (3) des Sicherheitsventils von einem an einen Hydrauliksteuerkreis angeschlossenen Stellzylinder (5) bei einem Druck des Mediums in der abzusichernden Anlage unterhalb des Ansprechdruckes in Offenstellung gehalten wird, und bei Überschreiten des Ansprechdruckes zur Erzielung des Ventilschließhubes ein oder mehrere von Druckaufnehmern (27,28,29) gesteuerte Abflußmagnetventile (16,17,18) öffnet und die Hydraulikflüssigkeit aus dem Stellzylinder (5) abführt, die bei Unterschreiten des Ansprechdruckes wieder öffnen, wobei dem Stellzylinder (5) für den Ventilöffnungsvorgang Hydraulikflüssigkeit zugeführt wird, **dadurch gekennzeichnet**, daß
a) eine oder mehrere vom Druck und der Druckänderungsgeschwindigkeit dp/dt bestimmte Kennlinien für den Hub des Verschlußkörpers (3) in Anpassung an die abzusichernde Anlage erstellt und in Form von Punkten der Kennlinien oder als Koeffizienten analytischer Funktionen elektronisch gespeichert sind,
b) der Mediumdruck über die Druckaufnehmer (27,28,29) in kurzer Taktzeit gemessen und gespeichert wird,
c) die Druckänderungsgeschwindigkeit in dieser Taktzeit in einem elektronischen Rechner errechnet und entsprechend den gespeicherten Kennlinen für jeden Takt die Größe des dazugehörigen Hubschrittes des Verschlußkörpers (3) für ein schrittweises Öffnen oder Schließen des Sicherheitsventiles (2) festgelegt wird,
d) der elektronische Rechner die pro Takt über ein oder mehrere schnellansprechende Abflußmagnetventile (16,17,18) abzuführende oder die über ein oder mehrere schnellansprechende Zuflußmagnetventile (34) zuzuführende Menge der Hydraulikflüssigkeit berechnet und hieraus die elektrischen Öffnungspulse der Magnetventile (16,17,18;34) für jeden Takt bestimmt und
e) diese Öffnungspulse über Verstärker an die Abfluß- und Zuflußmagnetventile (16,..;34) abgegeben werden, die den Öffnungs- oder Schließvorgang des Sicherheitsventiles (2) in Übereinstimmung mit den eingegebenen Kennlinien bei niedrigen Druckänderungsgeschwindigkeiten in kleinen Hubschritten und bei hohen Druckänderungsgeschwindigkeiten in großen Hubschritten oder in einem einzigen Schritt bis zur Hubendstellung steuern.

3. Verfahren nach Anspruch 1 oder 2, dadurch gekennzeichnet, daß die eingegebene Kennlinie oder die Kennlinien in einem zwischen einem unteren Ansprechdruck (Pu) und einem oberen Ansprechdruck (Po) vorgegebenen Druckbereich liegen und der Rechner in diesem Druckbereich im Takt die Berechnung der Öffnungspulse für die schnellansprechenden Magnetventile (16,34) durchführt, wobei der Rechner bei Überschreiten des oberen Ansprechdruckes (Po) anstelle der Öffnungspulse ein Daueröffnungssignal und bei Unterschreiten des unteren Ansprechdruckes (Pu) ein Dauerschließsignal an den auf die Abflußmagnetventile (16. .) einwirkenden Verstärker abgibt.

4. Verfahren nach einem oder mehreren der Ansprüche 1 bis 3 dadurch gekennzeichnet, daß die Berechnung der Öffnungspulse für die schnellansprechenden Magnetventile (16,34) im Rechner bis zu maximal hohen Grenzwerten der Druckänderungsgeschwindigkeit einerseits für den Öffnungsvorgang und andererseits für den Schließvorgang des Sicherheitsventiles (2) durchgeführt wird und daß bei Überschreiten dieser Grenzwerte vom Rechner bei steigendem Druck ein Daueröffnungssignal für die Abflußmagnetventile (16) und bei fallendem Druck ein Daueröffnungssignal für die Zuflußmagnetventile (34) an den Steuernden Verstärker abgegeben wird.

5. Verfahren nach einem oder mehreren der Ansprüche 1 bis 4, dadurch gekennzeichnet, daß die schnellansprechenden Magnetventile (26,43) mit veränderbarem Öffnungsquerschnitt versehen sind und diese Öffnungsquerschnittsänderungen elektronisch gespeichert und bei der Berechnung der Öffnungspulse für die Magnetventile (16,34) im Rechner berücksichtigt werden.

6. Verfahren nach Anspruch 5, dadurch gekennzeichnet, daß ein oder mehrere vorgesteuerte Magnetventile vorgesehen sind, bei denen bei kurzen Öffnungspulsen nur der Vorsteuerkegel mit kleinem Querschnitt öffnet und bei längeren Öffnungspulsen nach Überwindung der Totzeit für das Ansprechen des Hauptkegels der große Hauptkegelquerschnitt freigegeben wird.

7. Verfahren nach Anspruch 5, dadurch gekennzeichnet, daß mehrere schnellansprechende Magnetventile (16,34) mit gleichem oder unterschiedlichem Öffnungsquerschnitt in Parallelschaltung vorgesehen sind, von denen das oder die parallelgeschalteten Magnetventile bei großen ab- oder zuzuführenden Mengen der Hydraulikflüssigkeit zugeschaltet werden.

8. Verfahren nach einem oder mehreren der Ansprüche 1 bis 7, dadurch gekennzeichnet, daß die Anzugszeit und die Abfallzeit der schnellansprechenden Magnetventile (16,34) bei der Berechnung der Öffnungspulse als Korrekturgrößen berücksichtigt werden.

9. Verfahren nach Anspruch 8, dadurch gekennzeichnet, daß die sich durch Druck und Temperaturänderungen der Hydraulikflüssigkeit ergebenden Änderungen der Anzugs- und Abfallgeschwindigkeit der Magnetventile (16,34) als Korrekturgröße bei der Berechnung der Öffnungspulse berücksichtigt werden.

10. Verfahren nach einem oder mehreren der Ansprüche 1 bis 9, dadurch gekennzeichnet, daß der Belastungsdruck im Stellzylinder (5) im Takt gemessen und bei der Berechnung der Öffnungspulse für die Abflußmagnetventile (16) als Korrekturgröße berücksichtigt wird.

11. Verfahren nach einem oder mehreren der Ansprüche 1 bis 10, dadurch gekennzeichnet, daß die Druckdifferenz zwischen dem Druck im Speicher (12,13) des Hydrauliksteuerkreises und dem Belastungsdruck im Stellzylinder (5) im Takt gemessen und bei der Berechnung der Öffnungspulse des oder der Zuflußmagnetventile (34) als Korrekturgröße berücksichtigt wird.

12. Verfahren nach einem oder mehreren der Ansprüche 1 bis 11, dadurch gekennzeichnet, daß die jeweilige Hubstellung des Sicherheitsventils (2) als Istwert durch einen Wegaufnehmer (42) im Takt gemessen und dieser Istwert mit den errechneten Hubschritten verglichen wird, wobei bei auftretenden Differenzen die errechneten Öffnungspulse entsprechend korrigiert werden.

13. Verfahren nach einem oder mehreren der Ansprüche 1 bis 12, dadurch gekennzeichnet, daß die bekannte Temperatur-/Viskositäts-Kennlinie der Hydraulikflüssigkeit elektronisch gespeichert und die Temperatur der Hydraulikflüssigkeit im Takt gespeichert wird und die sich mit der Temperatur ändernde Viskosität und damit der sich ändernde Strömungswiderstand der Magnetventile (16,34) bei der Berechnung der Öffnungspulse berücksichtigt werden.

14. Verfahren nach einem oder mehreren der Ansprüche 1 bis 13, dadurch gekennzeichnet, daß bei Unterschreiten eines unteren Temperaturgrenzwertes der Hydraulikflüssigkeit eine Heizung zur Erwärmung der Hydraulikflüssigkeit und bei Überschreiten eines oberen Temperaturgrenzwertes eine Kühlung selbsttätig eingeschaltet wird.

15. Verfahren nach Anspruch 14, dadurch gekennzeichnet, daß bei Unterschreiten des unteren Temperaturgrenzwertes die Hydraulikpumpe (9) des Hydrauliksteuerkreises solange eingeschaltet wird bzw. bleibt, bissich die Hydraulikflüssigkeit durch die in Wärmeenergie umgewandelte Verlustleisung des Hydrauliksystems ausreichend erwärmt hat.

16. Verfahren nach einem oder mehreren der Ansprüche 1 bis 15, dadurch gekennzeichnet, daß die Zustandsgrößen mindestens der funktionswichtigsten elektrischen, elektronischen und hydraulischen Bauteile im Zyklus gemessen und mit elektronisch gespeicherten Grenzwerten im Rechner verglichen werden, der bei Grenzüberschreittungen entsprechende Störsignale abgibt.

17. Einrichtung zur Durchführung eines Verfahrens nach Anspruch 1 oder einem oder mehreren der Ansprüche 3 bis 16 zum Steuern von einem Sicherheitsventil (2) einer abzusichernden Anlage (1), bei welchem Verfahren der Verschlußkörper (3) des Sicherheitsventils von einem an einen Hydrauliksteuerkreis angeschlossenen Stellzylinder (5) gegen den Druck des Mediums in der abzusicherneden Anlage auf den Ventilsitz gedrückt wird, und bei Erreichen des Ansprechdruckes zur Erzielung des Ventilöffnungshubes ein oder mehrere von Druckaufnehmern (27,28,29) gesteuerte Abflußmagnetventile (16,17,18) öffnet und die Hydraulikflüssigkeit aus dem Stellzylinder (5) abführt, die bei Unterschreiten des Ansprechdruckes wieder schließen, wobei dem Stellzylinder (5) für den Ventilschließvorgang Hydraulikflüssigkeit zugeführt wird, dadurch gekennzeichnet, daß
a) eine oder mehrere vom Druck und der Druckänderungsgeschwindigkeit dp/dt bestimmte Kennlinien für den Hub des Verschlußkörpers (3) in Anpassung an die abzusichernde Anlage erstellt und in Form von Punkten der Kennlinien oder als Koeffizienten analytischer Funktionen in einem elektronischen Speicher gespeichert sind,
b) der Mediumdruck über die Druckaufnehmer (27,28,29) in kurzer Taktzeit gemessen und gespeichert wird,
c) die Druckänderungsgeschwindigkeit in dieser Taktzeit in einem elektronischen Rechner errechnet und entsprechend den gespeicherten Kennlinen für jeden Takt die Größe des dazugehörigen Hubschrittes des Verschlußkörpers (3) für ein schritweises Öffnen oder Schließen des Sicherheitsventiles (2) festgelegt wird,
d) der elektronische Rechner die pro Takt über ein oder mehrere schnellansprechende Abflußmagnetventile (16,17,18) abzuführende oder die über ein oder mehrere schnellansprechende Zuflußmagnetventile (34) zuzuführende Menge der Hydraulikflüssigkeit berechnet und hieraus die elektrischen Öffnungspulse der Magnetventile (16,17,18;34) für jeden Takt bestimmt und
e) diese Öffnungspulse über Verstärker an die Abfluß- und Zuflußmagnetventile (16,..;34) abgegeben werden, die den Öffnungs- oder Schließvorgang des Sicherheitsventiles (2) in Übereinstimmung mit den eingegebenen Kennlinien bei niedrigen Druckänderungsgeschwindigkeiten in kleinen Hubschritten und bei hohen Druckänderungsgeschwindigkeiten in großen Hubschritten oder in einem einzigen Schritt bis zur Hubendstellung steuern,
und daß die schnellansprechenden Abfluß- und Zuflußmagnetventile (16,17,18; 34) direkt an dem oder in unmittelbarer Nähe zu dem auf das Sicherheitsventil (2) aufgesetzten hydraulischen Stellzylinder (5) angeordnet sind und auch ein mit dem Auslaß (20,21) des oder der Abflußmagnetventile (16,17,18) verbundener Vorratsbehälter (11) sowie ein mit dem Einlaß des oder der Zuflußmagnetventile (34) verbundene Speicher (12,13) des Hydraulikkreislaufes an den oder in unmittelbarer Nähe zu den Magnetventilen (16,17,18;34) vorgesehen sind, und die zum Rechner, zum elektronischen Speicher, zum Verstärker und zu weiteren Modulen zusammengefaßten elektronischen Bauelemente eine Elektronikeinheit (22) bilden, an die einerseits mindestens ein an die abzusichernde Anlage (1) angeschlossener Druckaufnehmer (27) mit seinem elektrischen Signalausgang (26) und andererseits die Spulen (24,36) des oder der Abflußmagnetventile (16) sowie des oder der Zuflußmagnetventile (34) angekoppelt sind.

18. Einrichtung zur Durchführung eines Verfahren nach Anspruch 2 oder einem oder mehreren der Ansprüche 3 bis 16 zum Steuern von einem Sicherheitsventil (2) einer abzusicherenden Anlage (1), bei welchem Verfahren der Verschlußkörper (3) des Sicherheitsventils von einem an einen Hydrauliksteuerkreis angeschlossenen Stellzylinder (5) bei einem Druck des Mediums in der abzusichernden Anlage unterhalb des Ansprechdruckes in Offenstellung gehalten wird, und bei Überschreiten des Ansprechdruckes zur Erzielung des Ventilschließhubes ein oder mehrere von Druckaufnehmern (27,28,29) gesteuerte Abflußmagnetventile (16,17,18) öffnet und die Hydraulikflüssigkeit aus dem Stellzylinder (5) abführt, die bei Unterschreiten des Ansprechdruckes wieder öffnen, wobei dem Stellzylinder (5) für den Ventilöffnungsvorgang Hydraulikflüssigkeit zugeführt wird, dadurch gekennzeichnet, daß
a) eine oder mehrere vom Druck und der Druckänderungsgeschwindigkeit dp/dt bestimmte Kennlinien für den Hub des Verschlußkörpers (3) in Anpassung an die abzusichernde Anlage erstellt und in Form von Punkten der Kennlinien oder als Koeffizienten analytischer Funktionen in einem elektronischen Speicher gespeichert sind,
b) der Mediumdruck über die Druckaufnehmer (27,28,29) in kurzer Taktzeit gemessen und gespeichert wird,
c) die Druckänderungsgeschwindigkeit in dieser Taktzeit in einem elektronischen Rechner errechnet und entsprechend den gespeicherten Kennlinen für jeden Takt die Größe des dazugehörigen Hubschrittes des Verschlußkörpers (3) für ein schrittweises Öffnen oder Schließen des Sicherheitsventiles (2) festgelegt wird,
d) der elektronische Rechner die pro Takt über ein oder mehrere schnellansprechende Abflußmagnetventile (16,17,18 abzuführende oder die über ein oder mehrere schnellansprechende Zuflußmagnetventile (34) zuzuführende Menge der Hydraulikflüssigkeit berechnet und hieraus die elektrischen Öffnungspulse der Magnetventile (16,17,18;34) für jeden Takt bestimmt und
e) diese Öffnungspulse über Verstärker an die Abfluß- und Zuflußmagnetventile (16,..;34) abgegeben werden, die den Öffnungs- oder Schließvorgang des Sicherheitsventiles (2) in Übereinstimmung mit den eingegebenen Kennlinien bei niedrigen Druckänderungsgeschwindigkeiten in kleinen Hubschritten und bei hohen Druckänderungsgeschwindigkeiten in großen Hubschritten oder in einem einzigen Schritt bis zur Hubendstellung steuern,
und, daß die schnellansprechenden Abfluß- und Zuflußmagnetventile (16,17,18; 34) direkt an dem oder in unmittelbarer Nähe zu dem auf das Sicherheitsventil (2) aufgesetzten hydraulischen Stellzylinder (5) angeordnet sind und auch ein mit dem Auslaß (20,21) des oder der Abflußmagnetventile (16,17,18) verbundener Vorratsbehälter (11) sowie ein mit dem Einlaß des oder der Zuflußmagnetventile (34) verbundene Speicher (12,13) des Hydraulikkreislaufes an den oder in unmittelbarer Nähe zu den Magnetventilen (16,17,18;34) vorgesehen sind, und die zum Rechner, zum elektronischen Speicher, zum Verstärker und zu weiteren Modulen zusammengefaßten elektronischen Bauelemente eine Elektronikeinheit (22) bilden, an die einerseits mindestens ein an die abzusichernde Anlage (1) angeschlossener Druckaufnehmer (27) mit seinem elektrischen Signalausgang (26) und andererseits die Spulen (24,36) des oder der Abflußmagnetventile (16) sowie des oder der Zuflußmagnetventile (34) angekoppelt sind.

19. Einrichtung nach einem der Ansprüche 17 und 18, dadurch gekennzeichnet, daß entsprechend den sicherheitstechnischen Vorschriften drei unabhängig voneinander arbeitende Druckaufnehmer (27,28,29) für die Messung des Mediumdruckes und mindestens drei entsprechende, mit den Druckaufnehmern (27,28,29) zusammenwirkende Abflußmagnetventile (16,17,18) vorgesehen sind, wobei einer der Druckaufnehmer (27) mit dem Rechner der Elektronikbaueinheit (22) und die beiden anderen Druckaufnehmer (28,29) direkt mit den anderen Abflußmagnetventilen (17,18) in Verbindung stehen.

20. Einrichtung nach Anspruch 19, dadurch gekennzeichnet, daß die beiden direkt mit den Abflußmagnetventilen (17,18) in Verbindung stehenden Druckaufnehmer als Druckschalter (28,29) ausgebildet sind, deren Ansprechdruck auf einen Wert eingestellt ist, der gleich oder größer ist als der in der Elektronikbaueinheit (22) gespeicherte obere Ansprechdruck (Po).

21. Einrichtung nach einem oder mehreren der Ansprüche 18 und 19, dadurch gekennzeichnet, daß die Abfluß- oder Zuflußmagnetventile (16,17,18;34) sowie die Pumpe (9) mit dem Motor (19) und dem Speicher (12,13) sowie die übrigen Bauteile des Hydrauliksteuerkreises in einem topfartigen Gehäuse eingebaut sind, das gleichzeitig den Vorratsbehälter (11) für die Hydraulikflüssigkeit bildet.

22. Einrichtung nach Anspruch 21, dadurch gekennzeichnet, daß für eine explosionsgeschützte Ausführung alle Bauteile, die Zündfunken auslösen können, z.B. die Wicklung des Motors (10) und die Magnetventilspulen (24,32,33,36), so in den Vorratsbehälter (11) eingebaut sind, daß sie hoch genug von einem elektrisch nicht leitenden Hydrauliköl als Hydraulikflüssigkeit überdeckt sind.

23. Einrichtung nach den Ansprüchen 21 oder 22, dadurch gekennzeichnet, daß der alle Hydraulikteile (9,10,13,18,34) enthaltende Vorratsbehälter (11) direkt auf den Stellzylinder (5) aufgesetzt ist.

24. Einrichtung nach einem oder mehreren der Ansprüche 21 bis 23, dadurch gekennzeichnet, daß das den Vorratsbehälter (11) für die Hydraulikflüssigkeit bildende topfartige Gehäuse auf der Außenseite mit angegossenen Kühlrippen versehen ist.

25. Einrichtung nach einem oder mehreren der Ansprüche 21 bis 24, dadurch gekennzeichnet, daß im Hydraulikkreis zwei parallelgeschaltete Speicher (12,13) vorgesehen sind.

## Claims

1. Process for controlling a safety valve (2) of an installation to be protected, in which process the closure body (3) of the safety valve is pressed onto the valve seat by an operating cylinder (5), connected to a hydraulic control circuit, against the pressure of the medium in the installation to be protected, and upon reaching the response pressure for achieving the valve-opening stroke, opens one or more discharge solenoid valves (16, 17, 18), controlled by pressure sensors (27, 28, 29) and drains away the hydraulic fluid out of the operating cylinder (5) which valves close again when the pressure drops below the response pressure, hydraulic fluid being fed to the operating cylinder (5) for the valve-closing operation, characterised in that
a) one or more characteristic curves, determined by the pressure and the rate of pressure change dp/dt, for the lifting of the closure body (3) are created to match the installation to be protected and are stored electronically in the form of points of the characteristic curves or as coefficients of analytical functions,
b) the pressure of the medium is measured and stored by means of the pressure sensors (27, 28, 29) in a short cycle time,
c) the rate of pressure change in this cycle time is calculated in an electronic calculator and, according to the stored characteristic curves, for each clock the size of the associated lifting step of the closure body (3) for a step-by-step opening or closing of the safety valve (2) is fixed,
d) the electronic calculator calculates the quantity of hydraulic fluid per clock to be drained away via one or more quickly responding discharge solenoid valves (16, 17, 18) or to be fed via one or more quickly responding supply solenoid valves (34) and, from this, determines the electric opening pulses of the solenoid valves (16, 17, 18; 34) for each clock, and
e) these opening pulses are emitted via amplifiers to the discharge and supply solenoid valves (16, ....; 34) which control the opening or closing operation of the safety valve (2) in accord with the characteristic curves entered, in small lifting steps in the case of low rates of pressure change and in large lifting steps in the case of high rates of pressure change, or in a single step as far as the lifting end position.

2. Process for controlling a safety valve (2) of an installation to be protected, in which process the closure body (3) of the safety valve is kept in the open position by an operating cylinder (5), connected to a hydraulic control circuit, when the pressure of the medium in the installation to be protected is below the response pressure, and upon exceeding the response pressure for achieving the valve-closing stroke, opens one or more discharge solenoid valves (16, 17, 18), controlled by pressure sensors (27, 28, 29), and drains away the hydraulic fluid out of the operating cylinder (5), which valves open again when the pressure drops below the response pressure, hydraulic fluid being fed to the operating cylinder (5) for the valve-opening operation, characterised in that
a) one or more characteristic curves, determined by the pressure and the rate of pressure change dp/dt, for the lifting of the closure body (3) are created to match the installation to be protected and are stored electronically in the form of points of the characteristic curves or as coefficients of analytical functions,
b) the pressure of the medium is measured and stored by means of the pressure sensors (27, 28, 29) in a short cycle time,
c) the rate of pressure change in this cycle time is calculated in an electronic calculator and, according to the stored characteristic curves, for each clock the size of the associated lifting step of the closure body (3) for a step-by-step opening or closing of the safety valve (2) is fixed,
d) the electronic calculator calculates the quantity of hydraulic fluid per clock to be drained away via one or more quickly responding discharge solenoid valves (16, 17, 18) or to be fed via one or more quickly responding supply solenoid valves (34) and, from this, determines the electric opening pulses of the solenoid valves (16, 17, 18; 34) for each clock, and
e) these opening pulses are emitted via amplifiers to the discharge and supply solenoid valves (16, ....; 34) which control the opening or closing operation of the safety valve (2) in accord with the characteristic curves entered, in small lifting steps in the case of low rates of pressure change and in large lifting steps in the case of high rates of pressure change, or in a single step as far as the lifting end position.

3. Process according to Claim 1 or 2, characterised in that the characteristic curve or characteristic curves entered lie in a predetermined pressure range between a lower response pressure (Pu) and an upper response pressure (Po) and the calculator cyclically carries out the calculation of the opening pulses for the quickly responding solenoid valves (16, 34) in this pressure range, the calculator emitting to the amplifier acting on the discharge solenoid valves (16 ...) a permanent opening signal, instead of the opening pulses, if the pressure exceeds the upper response pressure (Po) and a permanent closing signal if the pressure drops below the lower response pressure (Pu).

4. Process according to one or more of Claims 1 to 3, characterised in that the calculation of the opening pulses for the quickly responding solenoid valves (16, 34) is carried out in the calculator, up to maximally high limit values of the rate of pressure change on the one hand for the opening operation and on the other hand for the closing operation of the safety valve (2) and in that, if these limit values are exceeded, a permanent opening signal for the discharge solenoid valve (16) is emitted by the calculator to the controlling amplifier in the case of rising pressure and a permanent opening signal for the supply solenoid valves (34) is emitted by the calculator to the controlling amplifier in the case of falling pressure.

5. Process according to one or more of Claims 1 to 4, characterised in that the quickly responding solenoid valves (26, 43) are provided with variable opening cross-section and these changes in opening cross-section are electronically stored and taken into account in the calculation of the opening pulses for the solenoid valves (16, 34) in the calculator.

6. Process according to Claim 5, characterised in that one or more pilot-controlled solenoid valves are provided, in which only the pilot-control cone with small cross-section opens in the case of short opening pulses and the large main cone cross-section is released in the case of longer opening pulses after overcoming the dead time for the response of the main cone.

7. Process according to Claim 5, characterised in that a plurality of quickly responding solenoid valves (16, 34) with the same or different opening cross-section are provided in parallel connection, of which the parallel-connected solenoid valve or valves are cut in in the case of large quantities of hydraulic fluid to be drained away or supplied.

8. Process according to one or more of Claims 1 to 7, characterised in that the pick-up time and the drop-out time of the quickly responding solenoid valves (16, 34) are taken into account in the calculation of the opening pulses as correcting quantities.

9. Process according to Claim 8, characterised in that the changes in the rate of pick-up and drop-out of the solenoid valves (16, 34), caused by pressure and temperature changes of the hydraulic fluid, are taken into account as a correction quantity in the calculation of the opening pulses.

10. Process according to one or more of Claims 1 to 9, characterised in that the loading pressure in the operating cylinder (5) is measured cyclically and is taken into account as a correction quantity in the calculation of the opening pulses for the discharge solenoid valves (16).

11. Process according to one or more of Claims 1 to 10, characterised in that the pressure difference between the pressure in the accumulator (12, 13) of the hydraulic control circuit and the loading pressure in the operating cylinder (5) is measured cyclically and taken into account as a correction quantity in the calculation of the opening pulses of the supply solenoid valve or valves (34).

12. Process according to one or more of Claims 1 to 11, characterised in that the respective lifting position of the safety valve (2) is measured cyclically as in actual value by a displacement sensor (42) and this actual value is compared with the calculated lifting steps, the calculated opening pulses being corrected appropriately if differences occur.

13. Process according to one or more of Claims 1 to 12, characterised in that the known temperature/viscosity characteristic curve of the hydraulic fluid is electronically stored and the temperature of the hydraulic fluid is stored cyclically and the viscosity changing with temperature, and consequently the changing flow resistance of the solenoid valves (16, 34), are taken into account in the calculation of the opening pulses.

14. Process according to one or more of Claims 1 to 13, characterised in that, if the temperature of the hydraulic fluid drops below a lower temperature limit value, a heating is automatically switched on for warming up the hydraulic fluid and, if the temperature exceeds an upper temperature limit value, a cooling is automatically switched on.

15. Process according to Claim 14, characterised in that, if the temperature drops below the lower temperature limit value, the hydraulic pump (9) of the hydraulic control circuit is switched on or remains switched on until the hydraulic fluid has warmed up sufficiently due to the power loss of the hydraulic system converted into thermal energy.

16. Process according to one or more of Claims 1 to 15, characterised in that the state variables of at least the functionally most important electric, electronic and hydraulic components are measured in the cycle and compared with electronically stored limit values in the calculator, which emits appropriate fault signals if limits are exceeded.

17. Device for carrying out a process according to Claim 1 or one or more of claims 3 to 16 for controlling a safety valve (2) of an installation (1) to be protected, in which process the closure body (3) of the safety valve is pressed onto the valve seat by an operating cylinder (5), connected to a hydraulic control circuit, against the pressure of the medium in the installation to be protected, and upon reaching the response pressure for achieving the valve-opening stroke, opens one or more discharge solenoid valves (16, 17, 18), controlled by pressure sensors (27, 28, 29), and drains away the hydraulic fluid out of the operating cylinder (5), which valves close again when the pressure drops below the response pressure, hydraulic fluid being fed to the operating cylinder (5) for the valve-closing operation, characterised in that
a) one or more characteristic curves, determined by the pressure and the rate of pressure change dp/dt, for the lifting of the closure body (3) are created to match the installation to be protected and are stored in an electronic memory, in the form of points of the characteristic curves or as coefficients of analytical functions,
b) the pressure of the medium is measured and stored by means of the pressure sensors (27, 28, 29) in a short cycle time,
c) the rate of pressure change in this cycle time is calculated in an electronic calculator and, according to the stored characteristic curves, for each clock the size of the associated lifting step of the closure body (3) for a step-by-step opening or closing of the safety valve (2) is fixed,
d) the electronic calculator calculates the quantity of hydraulic fluid per clock to be drained away via one or more quickly responding discharge solenoid valves (16, 17, 18) or to be fed via one or more quickly responding supply solenoid valves (34) and, from this, determines the electric opening pulses of the solenoid valves (16, 17, 18; 34) for each clock, and
e) these opening pulses are emitted via amplifiers to the discharge and supply solenoid valves (16, ....; 34) which control the opening or closing operation of the safety valve (2) in accord with the characteristic curves entered, in small lifting steps in the case of low rates of pressure change and in large lifting steps in the case of high rates of pressure change, or in a single step as far as the lifting end position,
and in that the quickly responding discharge and supply solenoid valves (16, 17, 18; 34) are arranged directly on the or in the direct vicinity of the hydraulic operating cylinder (5) set on the safety valve (2), and a storage tank (11), connected to the outlet (20, 21) of the discharge solenoid valve or valves (16, 17, 18), and an accumulator (12, 13) of the hydraulic circuit, connected to the inlet of the supply solenoid valve or valves (34), are provided on the or in the direct vicinity of the solenoid valves (16, 17, 18; 34), and the electronic components combined into the calculator, the electronic memory, the amplifier and other modules form an electronics unit (22), to which on the one hand at least one pressure sensor (27), connected to the installation (1) to be protected, is coupled by its electric signal output (26) and on the other hand the coils (24, 36) of the discharge solenoid valve or valves (16) and of the supply solenoid valve or valves (34) are coupled.

18. Device for carrying out a process according to Claim 2 or one or more of Claims 3 to 16, for controlling a safety valve (2) of an installation (1) to be protected, in which process the closure body (3) of the safety valve is kept in the open position by an operating cylinder (5), connected to a hydraulic control circuit, when the pressure of the medium in the installation to be protected is below the response pressure, and upon exceeding the response pressure for achieving the valve-closing stroke, opens one or more discharge solenoid valves (16, 17, 18), controlled by pressure sensors (27, 28, 29), and drains away the hydraulic fluid out of the operating cylinder (5), which valves open again when the pressure drops below the response pressure, hydraulic fluid being fed to the operating cylinder (5) for the valve-opening operation, characterised in that
a) one or more characteristic curves, determined by the pressure and the rate of pressure change dp/dt, for the lifting of the closure body (3) are created to match the installation to be protected and are stored electronically in the form of points of the characteristic curves or as coefficients of analytical functions,
b) the pressure of the medium is measured and stored by means of the pressure sensors (27, 28, 29) in a short cycle time,
c) the rate of pressure change in this cycle time is calculated in an electronic calculator and, according to the stored characteristic curves, for each clock the size of the associated lifting step of the closure body (3) for a step-by-step opening or closing of the safety valve (2) is fixed,
d) the electronic calculator calculates the quantity of hydraulic fluid per clock to be drained away via one or more quickly responding discharge solenoid valves (16, 17, 18) or to be fed via one or more quickly responding supply solenoid valves (34) and, from this, determines the electric opening pulses of the solenoid valves (16, 17, 18; 34) for each clock, and
e) these opening pulses are emitted via amplifiers to the discharge and supply solenoid valves (16, ....; 34) which control the opening or closing operation of the safety valve (2) in accord with the characteristic curves entered, in small lifting steps in the case of low rates of pressure change and in large lifting steps in the case of high rates of pressure change, or in a single step as far as the lifting end position,
and in that the quickly responding discharge and supply solenoid valves (16, 17, 18; 34) are arranged directly on the or in the direct vicinity of the hydraulic operating cylinder (5) set on the safety valve (2), and a storage tank (11), connected to the outlet (20, 21) of the discharge solenoid valve or valves (16, 17, 18), and an accumulator (12, 13) of the hydraulic circuit, connected to the inlet of the supply solenoid valve or valves (34), are provided on the or in the direct vicinity of the solenoid valves (16, 17, 18; 34), and the electronic components combined into the calculator, the electronic memory, the amplifier and other modules form an electronics unit (22), to which on the one hand at least one pressure sensor (27), connected to the installation (1) to be protected, is coupled by its electric signal output (26) and on the other hand the coils (24, 36) of the discharge solenoid valve or valves (16) and of the supply solenoid valve or valves (34) are coupled.

19. Device according to one of Claims 17 and 18, characterised in that, in conformity with the safety regulations, three pressure sensors (27, 28, 29) operating independently of one another are provided for measuring the pressure of the medium and at least three corresponding discharge solenoid valves (16, 17, 18), interacting with the pressure sensors (27, 28, 29) are provided, one of the pressure sensors (27) being in connection with the calculator of the electronics unit (22) and the two other pressure sensors (28, 29) being directly in connection with the other discharge solenoid valves (17, 18).

20. Device according to Claim 19, characterised in that the two pressure sensors directly in connection with the discharge solenoid valves (17, 18) are designed as pressure switches (28, 29), the response pressure of which is set to a value which is equal to or greater than the upper response pressure (Po) stored in the electronics unit (22).

21. Device according to one or more of Claims 18 and 19, characterised in that the discharge or supply solenoid valves (16, 17, 18; 34) and the pump (9) with the motor (19) and the accumulator (12, 13) as well as the other components of the hydraulic control circuit are built into a pot-like housing, which at the same time forms the storage tank (11) for the hydraulic fluid.

22. Device according to Claim 21, characterised in that, for an explosion-protected design, all the components which can set off ignition sparks, for example the winding of the motor (10) and the solenoid valve coils (24, 32, 33, 36), are built into the storage tank (11) in such a way that they are covered to a sufficient height by an electrically non-conductive hydraulic oil as the hydraulic fluid.

23. Device according to Claims 21 or 22, characterised in that the storage tank (11) containing all the hydraulic parts (9, 10; 13, 18, 34) is set directly on the operating cylinder (5).

24. Device according to one or more of Claims 21 to 23, characterised in that the pot-like housing forming the storage tank (11) for the hydraulic fluid is provided on the outside with cast-on cooling ribs.

25. Device according to one or more of Claims 21 to 24, characterised in that two parallel-connected accumulators (12, 13) are provided in the hydraulic circuit.

## Revendications

1. Méthode de commande d'une soupape de sécurité (2) d'une installation à protéger, méthode dans laquelle le corps d'obturation (3) de la soupape de sécurité est appliqué par un cylindre de réglage (5) connecté à un circuit de commande hydraulique sur le siège de soupape à l'encontre de la pression du milieu dans l'installation à protéger, et, une fois atteinte la pression de réponse nécessaire pour obtenir la course d'ouverture de soupape, ouvre une ou plusieurs électrovalves de décharge (16, 17, 18) contrôlées par des capteurs de pression (27, 28, 29) et évacue le liquide hydraulique hors du cylindre de réglage (5), ces dernières se fermant à nouveau quand la pression tombe en-dessous de la pression de réponse, du liquide hydraulique étant fourni au cylindre de réglage (5) pour le procédé de fermeture de soupape, caractérisée en ce que
a) une ou plusieurs courbes de fonctionnement déterminées à partir de la pression et de la vitesse de variation de pression dp/dt sont établies pour la course du corps d'obturation (3) en accord avec l'installation à protéger et sont enregistrées électroniquement sous la forme de points des courbes de fonctionnement ou en tant que coefficients de fonctions analytiques,
b) la pression du milieu est mesurée et enregistrée en un temps de cycle court par l'intermédiaire des capteurs de pression (27, 28, 29),
c) la vitesse de variation de pression dans ce temps de cycle est calculée dans une calculatrice électronique et, en accord avec les courbes de fonctionnement enregistrées pour chaque cycle, la grandeur de l'incrément de course correspondant du corps d'obturation (3) est établie pour une ouverture ou une fermeture progressive de la soupape de sécurité (2),
d) la calculatrice électronique calcule la quantité de liquide hydraulique à évacuer ou à fournir par cycle par l'intermédiaire respectivement d'électrovalves de décharge (16, 17, 18) ou d'alimentation (34) à temps de réponse rapide et on détermine l'impulsion électrique d'ouverture des électrovalves (16, 17, 18; 34) pour chaque cycle et
e) ces impulsions d'ouverture sont délivrées par l'entremise d'amplificateurs aux électrovalves de décharge et d'alimentation (16,...; 34) qui commandent le procédé d'ouverture ou de fermeture de la soupape de sécurité (2) on accord avec les courbes de fonctionnement introduites, par petits incréments de course en cas de faibles vitesses de variation de pression, et par grands incréments de course en cas de vitesses de variation de pression élevées ou par un seul incrément jusqu'á la position de fin de course.

2. Méthode de commande d'une soupape de sécurité (2) d'une installation à protéger, méthode dans laquelle le corps d'obturation (3) de la soupape de sécurité est maintenu en position d'ouverture à une pression du milieu dans l'installation à protéger en-dessous de la pression de réponse par un cylindre de réglage (5) connecté à un circuit de commande hydraulique, et, une fois dépassée la pression de réponse pour obtenir la course de fermeture de soupape, ouvre une ou plusieurs électrovalves de décharge (16, 17, 18) commandées par des capteurs de pression (27, 28, 29) et évacue le liquide hydraulique hors du cylindre de réglage (5), ces dernières s'ouvrant à nouveau quand la pression tombe en-dessous de la pression de réponse, du liquide hydraulique étant fourni au cylindre de réglage (5) pour le procédé d'ouverture de soupape, caractérisée en ce que
a) une ou plusieurs courbes de fonctionnement déterminées à partir de la pression et de la vitesse de variation de pression dp/dt sont établies pour la course du corps d'obturation (3) en accord avec l'installation à protéger et sont enregistrées électroniquement sous la forme de points des courbes de fonctionnement ou en tant que coefficients de fonctions analytiques,
b) la pression du milieu est mesurée et enregistrée en un temps de cycle court par l'intermédiaire des capteurs de pression (27, 28, 29),
c) la vitesse de variation de pression dans ce temps de cycle est calculée dans une calculatrice électronique et, en accord avec les courbes de fonctionnement enregistrées pour chaque cycle, la grandeur de l'incrément de course correspondant du corps d'obturation (3) est établie pour une ouverture ou une fermeture progressive de la soupape de sécurité (2),
d) la calculatrice électronique calcule la quantité de liquide hydraulique à évacuer ou à fournir par cycle par l'intermédiaire respectivement d'électrovalves de décharge (16, 17, 18) ou d'alimentation (34) à temps de réponse rapide et on détermine l'impulsion électrique d'ouverture des électrovalves (16, 17, 18; 34) pour chaque cycle et
e) ces impulsions d'ouverture sont délivrées par l'entremise d'amplificateurs aux électrovalves de décharge et d'alimentation (16,...; 34) qui commandent le procédé d'ouverture ou de fermeture de la soupape de sécurité (2) en accord avec les courbes de fonctionnement introduites, par petits incréments de course en cas de faibles vitesses de variation de pression, et par grands incréments de course en cas de vitesses de variation de pression élevées ou par un seul incrément jusqu'à la position de fin de course.

3. Méthode selon la revendication 1 ou 2, caractérisée en ce que la ou les courbes de fonctionnement introduites sont situées dans un domaine de pression prédéterminé entre une pression de réponse inférieure (Pi) et une pression de réponse supérieure (Ps) et en ce que le calculateur effectue dans ce domaine de pression en cycles le calcul de l'impulsion d'ouverture pour les électrovalves (16, 34) à temps de réponse rapide, le calculateur délivrant en cas de dépassement de la pression de réponse supérieure (Ps) à la place de l'impulsion d'ouverture un signal d'ouverture continu et, en cas de pression en-dessous de la pression de réponse inférieure (Pi) un signal de fermeture continu à l'intention des amplificateurs agissant sur les électrovalves de décharge (16,...).

4. Méthode selon l'une ou plusieurs des revendications 1 à 3, caractérisée en ce que le calcul de l'impulsion d'ouverture pour les électrovalves (16, 34) à temps de réponse rapide est effectué dans le calculateur jusqu'à des valeurs limite maximales de la vitesse de variation de la pression, d'une part pour le procédé d'ouverture et d'autre part pour le procédé de fermeture de la soupape de sécurité (2) et en ce que, en cas de dépassement de ces valeurs limite, est délivré, par le calculateur aux amplificateurs de commande, un signal d'ouverture continu pour les électrovalves de décharge (16) en cas de pression croissante et un signal d'ouverture continu pour les électrovalves d'alimentation (34) en cas de pression décroissante.

5. Méthode selon l'une ou plusieurs des revendications 1 à 4, caractérisée en ce que les électrovalves à temps de réponse rapide (26, 43) sont pourvues d'une section transversale d'ouverture variable et que ces variations de section transversale d'ouverture sont enregistrées électroniquement et peuvent être prises en compte dans le calculateur lors du calcul de l'impulsion d'ouverture pour les électrovalves (16, 34).

6. Méthode selon la revendication 5, caractérisée en ce qu'il est prévu une ou plusieurs électrovalves à soupape pilote, dans lesquelles, en cas d'impulsions d'ouverture courtes, s'ouvre uniquement le cône de commande pilote à faible section transversale et, en cas d'impulsions d'ouverture plus longues, la grande section transversale du cône principal est débloquée après passage du temps mort nécessaire à la réponse du cône principal.

7. Méthode selon la revendication 5, caractérisée en ce qu'il est prévu, en montage en parallèle, plusieurs électrovalves (16, 34) à temps de réponse rapide ayant une section transversale d'ouverture identique ou différente, auxquelles la ou les électrovalves montées en parallèle sont raccordées au cas ou de fortes quantités de liquide hydraulique sont à évacuer ou à fournir.

8. Méthode selon l'une ou plusieurs des revendications 1 à 7, caractérisée en ce que le temps d'actionnement et le temps de descente des électrovalves (16, 34) à temps de réponse rapide sont pris an compte en tant que grandeurs de correction lors du calcul de l'impulsion d'ouverture.

9. Méthode selon la revendication 8, caractérisée en ce que les variations du temps d'actionnement et de descente des électrovalves (16, 34) qui se produisent lors de variations de pression et de température du liquide hydraulique sont prises en compte en tant que grandeurs de correction lors du calcul de l'impulsion d'ouverture.

10. Méthode selon l'une ou plusieurs des revendications 1 à 9, caractérisée en ce que la pression de charge dans le cylindre de réglage (5) est mesurée en cycles et est prise en compte en tant que grandeur de correction lors du calcul lors du calcul de l'impulsion d'ouverture pour les électrovalves de décharge (16).

11. Méthode selon l'une ou plusieurs des revendications 1 à 10, caractérisée en ce que la différence de pression entre la pression dans le réservoir (12, 13) du circuit de commande hydraulique et la pression de charge dans le cylindre de réglage (5) est mesurée en cycles et est prise en compte en tant que grandeur de correction lors du calcul de l'impulsion d'ouverture du ou des électrovalves d'alimentation (34).

12. Méthode selon l'une ou plusieurs des revendications 1 à 11, caractérisée en ce que la position de course correspondante de la soupape de sécurité (2) est mesurée en cycles an tant que valeur instantanée par un capteur de déplacement (42) et en ce que cette valeur instantanée est comparée aux incréments de course calculés, l'impulsion d'ouverture calculée étant corrigée on conséquence si des différences se produisent.

13. Méthode selon l'une ou plusieurs des revendications 1 à 12, caractérisée en ce que les courbes de fonctionnement température/viscosité connues du liquide hydraulique sont enregistrées électroniquement et que la température du liquide hydraulique est enregistrée en cycles et que la viscosité, qui varie avec la température, et donc la résistance à l'écoulement des électrovalves (16, 34), qui varie, sont prises en compte lors du calcul de l'impulsion d'ouverture.

14. Méthode selon l'une ou plusieurs des revendications 1 à 13, caractérisée on ce que sont enclenchés automatiquement un chauffage pour réchauffer le liquide hydraulique, en cas de température en-dessous d'une valeur limite de température inférieure du liquide hydraulique, et un refroidisseur, en cas de dépassement d'une valeur limite de température supérieure.

15. Méthode selon la revendication 14, caractérisée en ce que la pompe hydraulique (9) du circuit de commande hydraulique est enclenchée ou reste enclenchée en cas de température en-dessous d'une valeur limite de la température limite inférieure, jusqu'à ce que le liquide hydraulique se soit réchauffé suffisamment en utilisant la puissance du système hydraulique dissipée et transformée en chaleur.

16. Méthode selon l'une ou plusieurs des revendications 1 à 15, caractérisée en ce que les variables d'état d'au moins les composants électriques, électroniques et hydrauliques les plus importants sont mesurés en cycle et comparés avec des valeurs limites enregistrées électroniquement dans le calculateur, qui délivre, en cas de dépassement des limites, des signaux de dérangement correspondants.

17. Dispositif pour la réalisation d'une méthode selon la revendication 1 ou l'une ou plusieurs des revendications 3 à 16, pour la commande d'une soupape de sécurité (2) d'une installation à protéger (1), méthode dans laquelle le corps d'obturation (3) de la soupape de sécurité est appliqué par un cylindre de réglage (5) connecté à un circuit de commande hydraulique sur le siège de soupape à l'encontre de la pression du milieu dans l'installation à protéger, et, une fois atteinte la pression de réponse nécessaire pour obtenir la course d'ouverture de soupape, ouvre une ou plusieurs électrovalves de décharge (16, 17, 18) contrôlées par des capteurs de pression (27, 28, 29) et évacue le liquide hydraulique hors du cylindre de réglage (5), ces dernières se fermant à nouveau quand la pression tombe en-dessous de la pression de réponse, du liquide hydraulique étant fourni au cylindre de réglage (5) pour le procédé de fermeture de soupape, caractérisé en ce que
a) une ou plusieurs courbes de fonctionnement déterminées à partir de la pression et de la vitesse de variation de pression dp/dt sont établies pour la course du corps d'obturation (3) en accord avec l'installation à protéger et sont enregistrées électroniquement sous la forme de points des courbes de fonctionnement ou en tant que coefficients de fonctions analytiques,
b) la pression du milieu est mesurée et enregistrée en un tempe de cycle court par l'intermédiaire des capteurs de pression (27, 28, 29),
c) la vitesse de variation de pression dans ce temps de cycle est calculée dans une calculatrice électronique et, en accord avec les courbes de fonctionnement enregistrées pour chaque cycle, la grandeur de l'incrément de course du corps d'obturation (3) est établie pour une ouverture ou une fermeture progressive de la soupape de sécurité (2),
d) la calculatrice électronique calcule la quantité de liquide hydraulique à évacuer ou à fournir par cycle par l'intermédiaire respectivement d'électrovalves de décharge (16, 17, 18) ou d'alimentation (34) à temps de réponse rapide et on détermine l'impulsion électrique d'ouverture des électrovalves (16, 17, 18; 34) pour chaque cycle et
e) ces impulsions d'ouverture sont délivrées par l'entremise d'amplificateurs aux électrovalves de décharge et d'alimentation (16,...; 34) qui commandent le procédé d'ouverture ou de fermeture de la soupape de sécurité (2) en accord avec les courbes de fonctionnement introduites, par petits incréments de course en cas de faibles vitesses de variation de pression, et par grands incréments de course en cas de vitesses de variation de pression élevées ou par un seul incrément jusqu'à la position de fin de course,
et en ce que les électrovalves de décharge et d'alimentation (16, 17, 18; 34) à temps de réponse rapide sont arrangées sur ou à proximité immédiate du cylindre de réglage hydraulique (5) placé sur la soupape de sécurité (2) et il est aussi prévu un réservoir de stockage (11) connecté à la sortie (20, 21) de la ou des électrovalves de décharge (16, 17, 18) ainsi qu'un réservoir (12, 13) du circuit hydraulique connecté à l'entrée de la ou des électrovalves d'alimentation (34) sur les, ou à proximité immédiate des électrovalves (16, 17, 18; 34) et les composants électroniques réunis à la calculatrice, à la mémoire électronique, à l'amplificateur et à d'autres modules constituent une unité électronique (22), à laquelle sont couplés d'une part au moins un capteur de pression (27), connecté à l'installation à protéger (1) avec son signal de sortie électrique (26) et, d'autre part, les bobines (24, 36) de la ou des électrovalves de décharge (16), ainsi que de la ou des électrovalves d'alimentation (34).

18. Dispositif pour la réalisation d'une méthode selon la revendication 2 ou l'une ou plusieurs des revendications 3 à 16, pour la commande d'une soupape de sécurité (2) d'une installation à protéger (1), méthode dans laquelle le corps d'obturation (3) de la soupape de sécurité est maintenu en position d'ouverture à une pression du milieu dans l'installation à protéger en-dessous de la pression de réponse par un cylindre de réglage (5) connecté à un circuit de commande hydraulique, et, une foie dépassée la pression de réponse pour obtenir la course de fermeture de soupape, ouvre une ou plusieurs électrovalves de décharge (16, 17, 18) commandées par des capteurs de pression (27, 28, 29) et évacue le liquide hydraulique hors du cylindre de réglage (5), ces dernières s'ouvrant à nouveau quand la pression tombe en-dessous de la pression de réponse, du liquide hydraulique étant fourni au cylindre de réglage (5) pour le procédé d'ouverture de soupape, caractérisé en ce que
a) une ou plusieurs courbes de fonctionnement déterminées à partir de la pression et de la vitesse de variation de pression dp/dt sont établies pour la course du corps d'obturation (3) en accord avec l'installation à protéger et sont enregistrées électroniquement sous la forme de points des courbes de fonctionnement ou en tant que coefficients de fonctions analytiques,
b) la pression du milieu est mesurée et enregistrée en un temps de cycle court par l'intermédiaire des capteurs de pression (27, 28, 29),
c) la vitesse de variation de pression dans ce temps de cycle est calculée dans une calculatrice électronique et, en accord avec les courbes de fonctionnement enregistrées pour chaque cycle, la grandeur de l'incrément de course correspondant du corps d'obturation (3) est établie pour une ouverture ou une fermeture progressive de la soupape de sécurité (2),
d) la calculatrice électronique calcule la quantité de liquide hydraulique à évacuer ou à fournir par cycle par l'intermédiaire respectivement d'électrovalves de décharge (16, 17, 18) ou d'alimentation (34) à temps de réponse rapide et on détermine l'impulsion électrique d'ouverture des électrovalves (16, 17, 18; 34) pour chaque cycle et
e) ces impulsions d'ouverture sont délivrées par l'entremise d'amplificateurs aux électrovalves de décharge et d'alimentation (16,...; 34) qui commandent le procédé d'ouverture ou de fermeture de la soupape de sécurité (2) en accord avec les courbes de fonctionnement introduites, par petits incréments de course en cas de faibles vitesses de variation de pression, et par grands incréments de course en cas de vitesses de variation de pression élevées ou par un seul incrément jusqu'à la position de fin de course,
et en ce que les électrovalves de décharge et d'alimentation (16, 17, 18; 34) à temps de réponse rapide sont arrangées sur ou à proximité immédiate du cylindre de réglage hydraulique (5) placé sur la soupape de sécurité (2) et il est aussi prévu un réservoir de stockage (11) connecté à la sortie (20, 21) de la ou des électrovalves de décharge (16, 17, 18) ainsi qu'un réservoir (12, 13) du circuit hydraulique connecté à l'entrée de la ou des électrovalves d'alimentation (34) sur les, ou à proximité immédiate des électrovalves (16, 17, 18; 34) et les composants électroniques réunis à la calculatrice, à la mémoire électronique, à l'amplificateur et à d'autres modules constituent une unité électronique (22), à laquelle sont couplées d'une part au moins un capteur de pression (27), connecté à l'installation à protéger (1) avec son signal de sortie électrique (26) et, d'autre part, les bobines (24, 36) de la ou des électrovalves de décharge (16), ainsi que de la ou des électrovalves d'alimentation (34).

19. Dispositif selon l'une quelconque des revendications 17 et 18, caractérisé en ce qu'il est prévu, conformément au règlement technique de sécurité, trois capteurs de pression (27, 28, 29) pour la mesure de la pression du milieu qui travaillent indépendamment l'un de l'autre et au moins trois électrovalves de décharge (16, 17, 18) correspondantes, coopérant avec les capteurs de pression (27, 28, 29), l'un des capteurs de pression (27) étant relié avec le calculateur de l'unité électronique (22) et les deux autres capteurs de pression (28, 29) étant directement reliés avec les autres électrovalves de décharge (17, 18).

20. Dispositif selon la revendication 19, caractérisé en ce que les deux capteurs de pression directement reliés avec les électrovalves de décharge (17, 18) sont configurés en tant qu'interrupteurs manométriques (28, 29), dont la pression de réponse est ajustée à une valeur qui est égale ou supérieure à la pression de réponse supérieure (Ps) enregistrée dans l'unité électronique (22).

21. Dispositif selon l'une ou plusieurs des revendications 18 et 19, caractérisé en ce que les électrovalves de décharge ou d'alimentation (16, 17, 18; 34) ainsi que la pompe (9) avec le moteur (19) et le réservoir (12, 13) ainsi que les autres composants du circuit de commande hydraulique sont incorporés dans un boîtier en forme de pot, qui constitue simultanément le réservoir de stockage (11) pour le liquide hydraulique.

22. Dispositif selon la revendication 21, caractérisé en ce que, dans l'optique d'une réalisation anti-déflagration, tous les composants qui peuvent provoquer des étincelles d'allumage, par exemple l'enroulement du moteur (10) et les bobines (24, 32, 33, 36) des électrovalves, sont incorporés dans le réservoir de stockage (11) de telle manière qu'ils soient recouverts à un niveau suffisamments élevé par une huile hydraulique non conductrice servant de liquide hydraulique.

23. Dispositif selon la revendication 21 ou 22, caractérisé en ce que le réservoir de stockage (11) qui contient tous les composants hydrauliques (9, 10, 13, 18, 34) est placé directement sur le cylindre de réglage (5).

24. Dispositif selon l'une ou plusieurs des revendications 21 à 23, caractérisé en ce que le boîtier en forme de pot qui constitue le réservoir de stockage (11) pour le liquide hydraulique est pourvu sur le côté extérieur des ailettes de refroidissement faisant corps par moulage avec ce dernier.

25. Dispositif selon l'une ou plusieurs des revendications 21 à 24, caractérisé en ce qu'il est prévu dans le circuit hydraulique deux réservoirs (12, 13) montés en parallèle.
